# EUROPEAN PATENT SPECIFICATION

(11) **EP 3 869 534 B1**
(45) Date of publication and mention of the grant of the patent: **21.10.2026**
(21) Application number: 20158398.6
(22) Date of filing: 20.02.2020
(51) Int. Cl.: H01J 37/22, H01J 37/304, H01J 37/305, G01B 11/06

(54) **SYSTEM FOR MEASURING IN-SITU A VOLUME ETCH RATE OF AN ION BEAM**
SYSTEM ZUR IN-SITU-MESSUNG EINER VOLUMEN-ÄTZRATE EINES IONENSTRAHLS
SYSTÈME DE MESURE IN SITU DU TAUX DE GRAVURE VOLUMIQUE D'UN FAISCEAU IONIQUE

(43) Date of publication of application: 25.08.2021
(73) Proprietor: Bühler Alzenau GmbH, 63755 Alzenau (DE)
(72) Inventor: Gürtler, Steffen, 04564 Böhlen (DE); Berlinger, Mario, 04279 Leipzig (DE); Sperling, Ralf, 04289 Leipzig (DE)
(74) Representative: Vossius & Partner Patentanwälte Rechtsanwälte mbB

(56) References cited:
- JP-A- S59 150 534
- US-A- 5 947 053
- US-A1- 2007 100 580
- US-A1- 2009 001 282
- US-A1- 2009 065 478
- S. GÜRTLER ET AL: "ISERM: in-situ etch rate measurement system", SPIE - INTERNATIONAL SOCIETY FOR OPTICAL ENGINEERING. PROCEEDINGS, vol. 10009, 30 June 2016 (2016-06-30), US, pages 100090N, XP055715549, ISSN: 0277-786X, ISBN: 978-1-5106-3549-4, DOI: 10.1117/12.2236642

## Description

The invention relates to an in-situ volume etch rate system and a method thereof.

Ion beam etching is a common tool for polishing and shaping of samples of various materials, e.g. optical components or thin films. In particular, an ion beam is a type of charged particle beam consisting of ions. A variety of ion beam sources exists, where the most common ion beams are of singly-charged ions.

The ion beam is directed onto a sample's surface where the impact of the ions erodes the sample's surface, abrading away (etching) a certain amount of material. The amount of material that is etched away by the ion beam depends, for example, on the ion beam parameters, the material composition of the sample and the time of exposure. The etch rate is defined as the amount of material removed from the sample's surface over time.

The ion beam is typically focused onto the sample's surface and has a Gaussian profile with a peak (maximum of the Gaussian ion beam profile) and a full width at half maximum (FWHM). The etch profile of the sample's surface can thus also be characterized by a peak etch rate and a FWHM.

In prior art systems, in order to determine the etch rate of the ion beam for a specific sample, a sample probe (reference sample) is pre-characterized using an interferometric measurement device based on surface form interferometric measurements, e.g. using a Fizeau-interferometer. Subsequently the sample probe is inserted into a vacuum chamber. The sample probe is ideally of the same material as the actual sample to be exposed to the ion beam afterwards. The sample probe is exposed to the ion beam for a predetermined amount of time using predetermined beam parameters, so-called footprint etching. The sample probe is taken out of the vacuum chamber and the etched profile is subsequently measured ex-situ by the interferometric device based on surface interferometric measurements. Thus, the peak etch rate, the FWHM and the etched volume can be deteremined. Thereafter, the actual sample is inserted into the vacuum chamber and processed in accordance with the determined etching parameters of the ion beam.

However, the prior art systems require a time consuming process to determine the etch rate parameters of the ion beam as the sample probe has to be inserted into and taken out of the vacuum chamber in addition to performing the aforementioned interferometric measurements before and after ion beam etching.

In addition, the sample probes have a limited lifetime, because the fringes of the surface form interferometric measurements can only be resolved for a certain depth of the etching profiles. That is, after a certain amount of etching on the sample probe, the depth of the etched profile cannot be resolved anymore by the prior art interferometric measurement devices. Such sample probes have to be exchanged regularly or newly polished, which is cost intensive.

Moreover, in order to determine the full ion beam profile, i.e. the volume etch rate, prior art systems have to use sample probes that are three to four times the size of the ion beam diameter, which necessitates large reference objects for the interferometric measurements and restricts the metrology and is cost intensive at the same time.

Similar problems arise in conventional deposition methods, where the deposition rate is measured ex-situ, i.e. before inserting the sample into the vacuum chamber for material deposition and after extracting the sample from the vacuum chamber.

US 2007/100580 A1 relates to measuring the thickness of a layer of material during or after it is deposited on a substrate and also relates to determining the relative concentration of a deposited component of the layer during or after deposition.

US 2009/065478 A1 relates to providing physical measurements of the thickness of a material and more particularly relates to measuring the thickness and rate of etching, and composition of such etched material while the material is being etched.

The object of the present invention is to overcome the above mentioned deficiencies of the prior art systems. The present invention is defined by the independent claims. Dependent claims relate to preferred embodiments of the present invention.

The system for in-situ ion beam volume etch rate measurement according to the invention comprises an interferometric measurement device which may at least partially be located within the vacuum chamber, e.g. a sensor and an optical fiber may be located within the vacuum chamber, while other elements such as power supply, controller and other components of the interferometric measurement device may be located outside the vacuum chamber.

The interferometric measurement device may be configured to determine the etch rate while etching the first surface of the sample, preferably after a predetermined stabilization time, preferably more than 2 minutes, more preferably more than 3 minutes, even more preferably more than 4 minutes, and most preferably 4-5 minutes or longer. That is, the etch rate measurement may be performed at the same time as the etching is being performed.

The interferometric measurement device may be a high precision optical low-coherence interferometer, HP-OLCI.

The HP-OLCI as analyzing unit may be an interlaced interferometer and may be based on optical coherence tomography, OCT, technology. It may comprise two internal and two external arms. One internal arm may be equipped with a voice coil, which provides through its throw the working field. The second internal arm may be movable to provide scan range (thickness preferably 0-135 mm).

One external arm may be constituted by the sensor itself within the vacuum chamber of the ion beam figuring, IBF. The second arm may be an adjustable reference. This reference may be formed by an air gap. Both external arms may provide a signal; thickness is measured by the determination of the distance between both signals. For example, a DFB laser with 1550 nm may serve as scale.

The reference arm may be used to set an air gap with the optical thickness of the sample. The air gap may be generated from a glass plate (e.g. fused silica), which is movable (e.g. 135 mm) and a mirror. The HP-OLCI may consider only the interference burst of the interface and may compare it with the interference burst of the interface of the air gap (transition from fused silica to air). If both signals lie on top of each other, the thickness difference is zero. If the surface of the sample is etched off by the ion beam, the interference burst moves away from the reference burst. The distance between the two is determined with high precision by the maxima of the two bursts and the DFB laser interference signal (scale). The change over time may be output in nm/s and can be measured more precisely than 0.1 nm/s.

In other words, HP-OLCI is a highly accurate comparative thickness measurement device.

The reference signal is normally generated by a sample whose thickness is known exactly and the difference to this reference sample is to be determined. The absolute thickness is not important for the present invention. Rather, the change over time is determined. Thus, an air gap may be used, which has the advantage of being variable.

The second surface of the sample is opposite the first surface of the sample. That is, one side of the sample is etched using the ion beam and the opposite side used to measure the etch rate.

The interferometric measurement device may be configured to determine the thickness of the sample over time and to determine the volume etch rate based on the thickness variation of the sample over time.

The interferometric measurement device may comprises a sensor configured to direct the light onto the second surface of the sample and to collect light reflected back from the sample.

The sensor may comprise optical components to direct the light onto the second surface of the sample and to collect light reflected back from the sample.

The sensor may be located within the vacuum chamber.

The sensor may comprise the sample. That is, according to a preferred embodiment, the sample may be located inside the sensor.

The sensor may comprise a housing and the sample may be located inside the housing, preferably with the optical components also located inside the housing.

The housing may comprise an opening and the sample may be located at the opening such that the ion beam or the material to be deposited can reach the sample's first surface through the opening. In other words, the sample's first surface may be located at the opening of the housing.

The housing may comprise a graphite outer surface. Thus, leaving only the sample in exposition to the ion beam or the material to be deposited.

The interferometric measurement device may comprise a cooling device, e.g. a copper cooling device, in contact with the sample and may be configured to cool the sample.

The interferometric measurement device comprises a positioning device configured to position the light at at least one predetermined location onto the second surface of the sample. The positioning device may be a x,y,z-stage on which the optical components may be mounted so that the optical components may be moved in three dimensions. In some embodiments also a two-dimensional x,y-stage may be sufficient to move the optical components in two-dimensions, preferably in parallel to the sample's second surface.

The controller may be configured to control the positioning device to position the light at the second surface of the sample at a location corresponding to the center of the ion beam to determine a peak etch rate of the ion beam.

The peak etch rate may be defined as the etch rate at the maximum intensity of the ion beam, wherein the ion beam has a substantially Gaussian form.

The controller is further configured to control the positioning device to position the light at the second surface of the sample at a plurality of locations corresponding to locations within the ion beam profile to determine an etch rate of the ion beam profile.

For example, by obtaining several measurements at different locations corresponding to locations within the ion beam profile, a Gaussian fit can be used to determine the volume etch rate of the ion beam profile.

The system may further comprise an alignment device configured to align the ion beam with respect to the first surface of the sample.

The alignment device may comprise a Faraday cup and a position camera or a characterization device configured to characterize the ion beam by a point-scan and to calculate the offset to an initial start point.

According to a further aspect of the invention a method for in-situ ion beam volume etch rate as defined in appended claim 12.

Normally, the sample (also called sample probe) as described herein may relate to the actual sample on which the ion beam processing or the deposition is finally to be executed or to a test sample to determine the ion beam etch rate or the deposition rate. This test sample should ideally be of the same material as the actual sample on which the ion beam processing or the deposition is finally to be executed.

In particular, if the sample is thin enough, the present invention may be used to measure the sample while etching the sample or during material deposition onto the sample without the need for using a test sample. For example, this "live" measurement on the actual sample while etching may be used to determine the etch rate by determining the center thickness of an optical lense. If the temperatures are expected to be high, a thin sample, e.g. having an optical thickness of up to 135 mm, may be advantageous since heat dissipation in thin samples is easier compared to thick samples. In other words, heat on the sample may be removed more effectively from thin samples due to the fact that optical materials may tend to be bad heat conductors.

However, in case of a constant temperature inside the sample, there is no restriction in the thickness of the sample. In any case, it is preferable to have a constant temperature inside the sample.

As apperent from the above description of the present invention, the present invention provides a system and method that reduces processing time in that the interferometric measuerements of the sample can be executed in-situ. Thus, time consuming insertion and extraction of the sampe into and out of the vacuum chamber can be avoided. In addition, the sample does not have to be measured before and after ion beam etching or material deposition, which saves additional time.

In addition, by the present invention, the sample can be used (reused) more often without the necessity to exchanged or newly polish the sample due to use of a thickness based interefrrometric measurement and thus costs may be saved.

Moreover, the present invention does not require the sample to be three to four times the size of the ion beam diameter for determining the etching profile of the ion beam due to use of a thickness based interefrrometric measurement, which again saves costs.

Further, the present invention allows for etch rate measurements under a non-orthogonal impact angle. This is particularly advantageous for highly curved samples, where the respective positioning system may not be able to allow for perfect orthogonal impact angles over the whole extend of the sample.

More particular, the etch rate is highly influenced by the impact angle and is different between different materials. The possibility for etch rate determination for such non-orthogonal impact angles is one of the advantegous of the present invention.

These and other features, advantages and aspects of the present invention will become apparent from the following description of the figures outlining exemplary embodiments of the present invention. The following description of exemplary embodiments of the present invention is not to be construed limiting for the scope of the present invention. Rather, the exemplary embodiments are intended to provide some non-exhaustive examples of how to implement the present invention. It will be apparent to the skilled person that the present invention is not limited by the combination of features of the following esemplary embodiments. Rather, features of different exemplary embodiments may be combined with features of other exemplary embodiments if not explicitly stated otherwise. That is, the scope of the present invention is solely defined by the features of the independent claims 1 and 12

Some preferred embodiments are now described with reference to the drawings, where:
Fig. 1 illustrates one preferred embodiment of the system of the present invention,
Fig. 2 illustrates another embodiment of the system of the present invention,
Fig. 3 illustrates a flow chart of of steps used in the method of the present invention,
Fig. 4 illustrates a sample probe with differently etched footprints using different ion beam parameters,
Fig. 5 illustrates in-situ raw etch rate measurements on a sample using different ion beam parameters,
Fig. 6 illustrates in-situ raw etch rate measurements on a sample,
Fig. 7(a)-(e) illustrates a 48 hour measurement of the source stability measured each hour;
Fig. 8 is a graph showing the sample thickness during the geometry determination;
Fig. 9 illustrates the sample thickness during geometry determination, and
Fig. 10 illustrates a system to determine the deposition rate in situ that does not form part of the claimed invention.

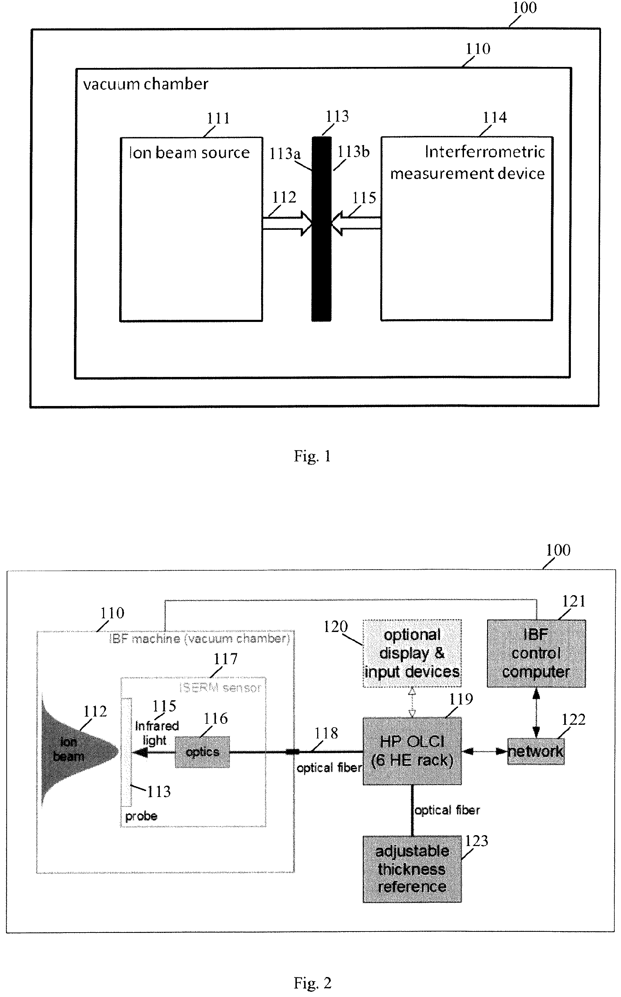

With reference to Fig. 1 one preferred embodiment of the system of the present invention is described. Fig. 1 shows a system 100 for in-situ ion beam etch rate measurement. The system comprises a vacuum chamber 110, an ion beam source 111 and an interferometric measurement device 114.

The ion beam source 111 is configured to direct an ion beam 112 onto a first surface 113a of a sample 113 located within the vacuum chamber 110 and to etch the first surface 113a of the sample 113 with a certain etch rate.

The interferometric measurement device 114 is located at least partially within the vacuum chamber 110 and configured to direct light 115 onto a second surface 113b of the sample 113 and to determine the etch rate of the ion beam 112 in-situ based on light reflected from the sample 113.

The interferometric measurement device 114 may be a low coherence interferometer, e.g. build up of two entangled Michelson-interferometers having a modulator arm with a scanning range of approximately 400 micrometer, a measurement range arm (adjustable range between 0-135 mm thickness), the actual measurement arm, which is adjusted on the reference sample and an adjustable reference arm, which provides the reference signal for the thickness measurement. The light sources may be a combination of super luminescence diodes with a center wavelength of 1280 nm and 1310 nm. As a measure, a distributed feedback, DFB, laser with a wavelength of 1550 nm is coupled in for the interferometric measurement of the paths. This is just one example of an interferometric measurement device that can be used with the present invention. However, the present invention is not limited thereto. Any interferometric measurement device 114 which is able to determine the thickness of the sample 113 can be used together with the present invention. The aforementioned set-up of the interferometric measurement device 114 may, however, be advantegous over other such interferometric measurement device in terms of precision.

Fig. 2 illustrates another embodiment of the system 100 of the present invention. In particular, Fig. 2 illustrates the features already described with reference to Fig. 1 and further optional features of the system 100.

In particular, Fig. 2 shows the vacuum chamber 110, the ion beam 112, the sample 113, the light 115, optical components 116, a sensor 117, an optical fiber 118, a high precision optical low-coherence interferometer, HP-OLCI, rack 119, a display and input device 120, an ion beam figuring, IBF, control computer 121, a network device 122, and an adjustable thickness reference module 123.

The ion beam 112, the sample 113, the light 115, the optical components 116, the sensor 117, and partly the otpical fiber 118 are located within the vacuum chamber 110. The sample 113 and the optical components 116 are located within the sensor 117.

The ion beam 112 is directed onto the sample's first surface 113a, e.g. through an opening (not shown) in the sensor's housing. The light 115, e.g. infrared light, is directed (focused) onto the opposite surface (second surface 113b) of the sample 113 by the optical components 116, wherein the light is provided to the optical components 116 through an optical fiber 118.

The sample 113 is located on an inner surface of the sensor 117, i.e. the sensor housing. The opening (not shown) in the sensor's housing is provided such that the sample's first surface 113a is partially exposed to the ion beam 112.

The optical components 116 are configured to focus the light 115 onto the sample's second surface 113b and to collect light reflected from the sample's surfaces 113a, 113b. The light reflected back from the sample's surfaces 113a, 113b gives rise to a unique interference pattern. By comparing this interference pattern with an interference pattern from a comparison sample in the adjustable thickness reference module 123, the thickness of the sample 113 can be determined.

For example, the interference patterns may comprise interference bursts, where the envelope of the interference bursts may be used to determine the thickness of the sample 113. In order to increase the accuracy of the thickness determination, the distance between the interference bursts may be used to determine the thickness of the sample 113.

It is even more preferable to evaluate the entire burst itself to further increase the accuracy.

The HP-OLCI rack 119 is connected to the optical components 116 via an optical fiber 118 and with the adjustable thickness reference module 123 via another optical fiber. The HP-OLCI rack 119 comprises the power supply, the light source(s) and respective control means for the HP-OLCI. The control means may be used to control the functionality of the interferometric measurement device 114 and may comprise a processing device, e.g. a processor, which may be configured to determine the thickness of the sample 113 based on the interferometric measurements and subsequently to determine the etch rate, i.e. the thickness variation over time.

The system 100 may also provide a display and input device 120 for displaying the results of said determination of the etch rate and to receive user input for controlling the different functions of the interferometric measurement device, e.g. the amplification andintensity of the light 115 onto the sample's second surface 113b and/or perform adjustments on the adjustable thickness reference module 123.

Controlling the amplification and intensity of the light 115 is advantegous because the light reflected from the sample's surface and therefore the intensity depends on the material of the sample. In addition, the intensity can decrease with increasing lifetime of the sample. Thus, to provide for sufficient intensity of the reflected light, the amplification and intensity of the light 115 directed to the sample's second surface 133b can be regulated.

The ion beam 112, i.e. the parameters of the ion beam 112 and the location of the ion beam 112 with respect to the sample, is controlled using the IBF control computer 121. Although not shown in detail in Fig. 2, the IBF machine provides the ion beam 112 and comprises the vacuum chamber 110.

Both the IBF control computer 121 and the HP-OLCI rack 119 are connected to a network 122 to provide centralized control over the ione beam 112 and the interferometric measurement device 114.

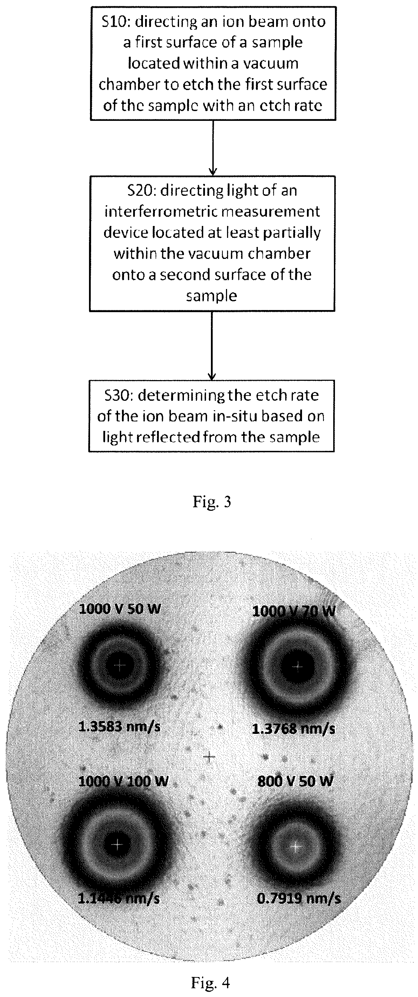

Fig. 3 illustrates a flow chart of steps used in the method of the present invention. In particular, Fig. 3 shows a first step S10 of directing an ion beam 112 onto a first surface 113a of a sample 113 located within a vacuum chamber 110 to etch the first surface 133a of the sample 113 with an etch rate.

At a second step S20 light 115 of an interferometric measurement device 114 located at least partially within the vacuum chamber 110 is directed onto a second surface 113b of the sample 113.

At step S30 the etch rate of the ion beam 112 is determined in-situ based on light reflected from the sample 113.

Fig. 4 illustrates a sample probe with differently etched footprints using different ion beam parameters. In particular, the sample probe's surface is characterized, i.e. interferometric surface measurements are performed on the sample probe, before inserting the sample into the vacuum chamber. Subsequently, the footprints are etched into the sample probe's surface using the ion beam. The ion beam parameters are varied as follows: a) 1000 V and 50 W (upper left footprint in Fig. 4), b) 1000 V and 70 W (upper right footprint in Fig. 4), c) 1000 V and 100 W (lower left footprint in Fig. 4), and d) 800 V and 50 W (lower right footprint in Fig. 4). In a further step the sample probe is taken out of the vacuum chamber and the interferometric surface measurements are performed again to determine the etch rate of the different footprints. This corresponds to a prior art procedure.

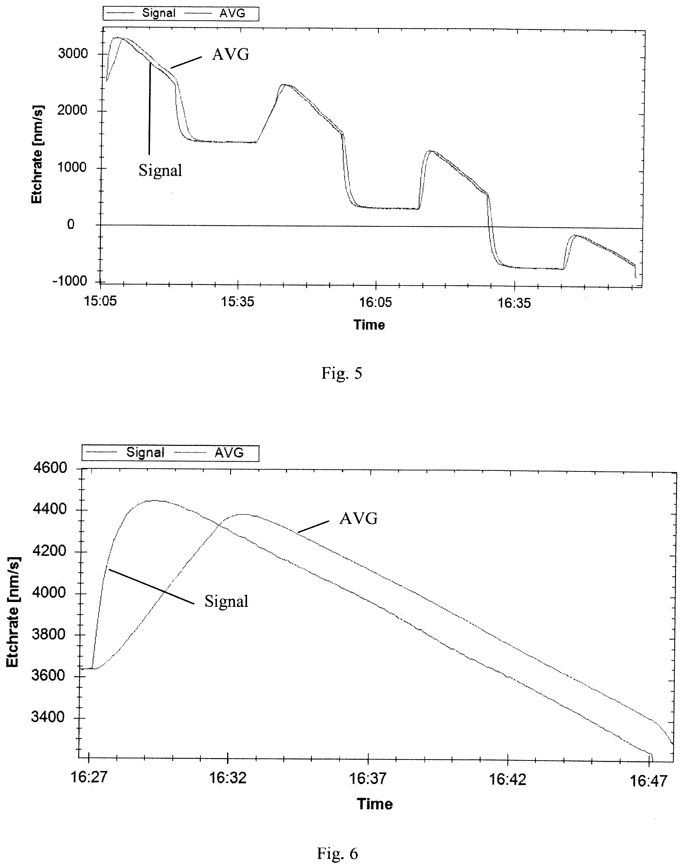

For comparison, a sample of the same material, in this case fused silica, is measured using the present invention, i.e. in-situ, while the same beam parameters are used. The raw values obtained by the in-situ measurement, i.e. the thickness over time, is illustrated in Fig. 5 (together with the rolling mean values). Each measurement was performed for 20 minutes and a new measurement was started after 5 minutes after the previous measurement.

As can be seen from Fig. 5, the thickness initially, i.e. in the first 4-5 minutes, increases, which is due to effects of thermal expansion and change of optical index with increasing temperature. By using active cooling of the sample, it is possible to achieve stable conditions after 4-5 minutes, depending on neutralizer and beam power.

The beam geometry can be gained by running a point scan, i.e. measurements at different locations on the sample's surface. An initial heat up time (4-5 minutes) is needed for the first measuring-point, all other points only need 1-2 minutes heat up time to stabilize the measurement. The measurement points are preferably scanned in a spiral manner beginning in the center and advancing more outward. Thus, energy input can be kept almost constant and the required time for each measuring point can be reduced.

**Table 1**

| | Peak etchrate in nm/s | | | |
|---|---|---|---|---|
| Sample | ISERM | Interferometric method | Factor | Error in nm/s |
| 1 | 1,061378412 | 1,1578 | 0,916719996 | 0,09642159 |
| 2 | 1,271374238 | 1,2821 | 0,991634224 | 0,01072576 |
| 3 | 1,324530057 | 1,3943 | 0,949960594 | 0,06976994 |
| 4 | 1,121599131 | 1,129 | 0,993444758 | 0,00740087 |
| 5 | 1,079770321 | 1,0722 | 1,00706055 | 0,00757032 |
| 6 | 1,187326918 | 1,1944 | 0,99407813 | 0,00707308 |
| 7 | 1,189589273 | 1,1962 | 0,994473561 | 0,00661073 |
| 8 | 1,178635264 | 1,2135 | 0,971269274 | 0,03486474 |
| 9 | 1,162560841 | 1,1449 | 1,015425662 | 0,01766084 |

Table 1 shows nine comparison measurements between a conventional interferometric measurement on a 3 inch probe fused silica and a 1 inch 1 mm sample of the measurement device according to the present invention (in-situ etch rate measurement - ISERM). Depending on the manufacturing process of the material, the etch rate may vary significantly. Therefore, the reference sample of the measurement device should be made of the same material as the sample to be processed. Otherwise, a correction factor may be determined beforehand to account for the respective variation.

Fig. 6 is a beam scan graph showing the signal as well as the average values of the etch rate over time using the present invention. After an initial heat up of the sample, the etch rate decreases continuously.

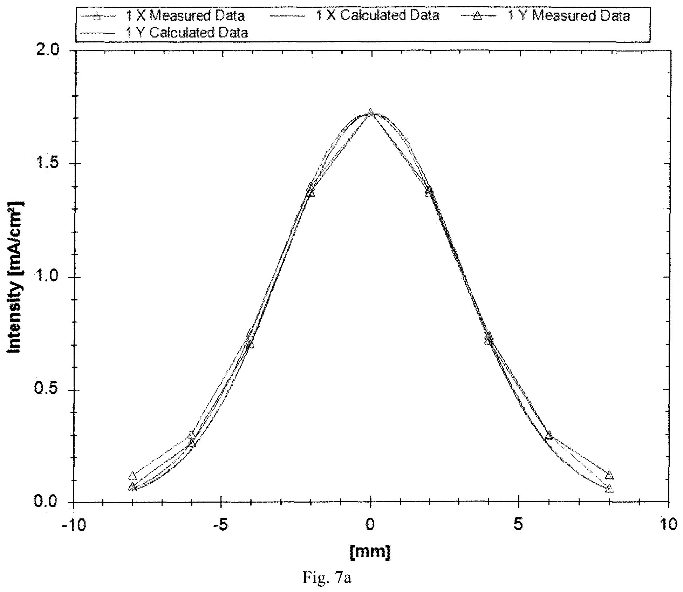

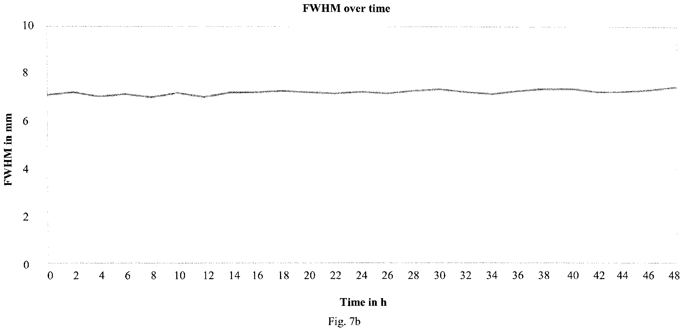

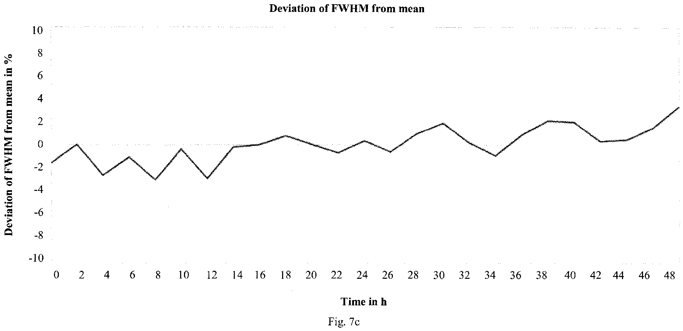

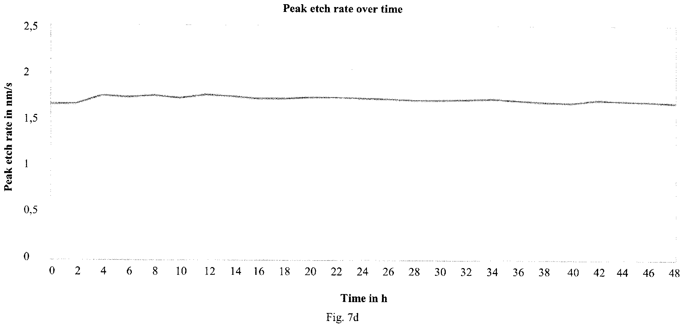

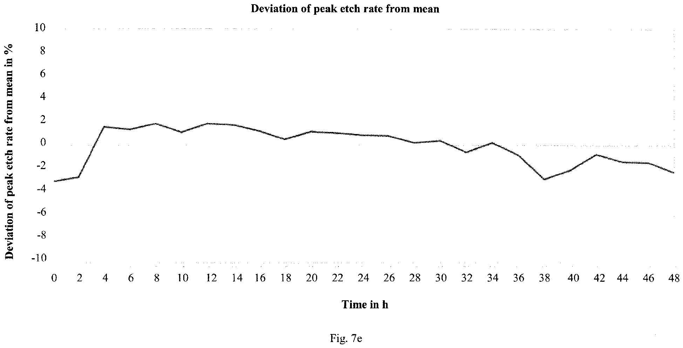

Fig. 7(a)-(e) depict a 48 hour measurement of the source stability. In particular, measurement values were taken every hour to obtain a stability of the peak etch rate (see Fig. 7(d)), full width half max (FWHM) over time (Fig. 7(b)) and the respective deviations thereof (Figs. 7(c) and 7(e)). Fig. 7(a) shows one example measurement of the 48 hour measurement. As can be seen from the figures, a stable peak etch rate and FWHM was achieved during the long time measurement using the present invention.

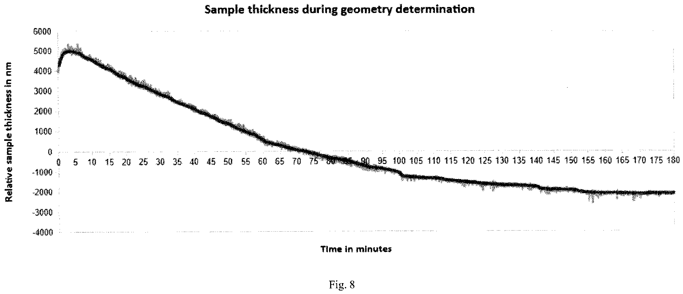

Fig. 8 is a graph showing the sample thickness during the geometry determination. Again, after an initial heat up of the sample, where the sample thickness increases, the relative sample thickness decreases over time.

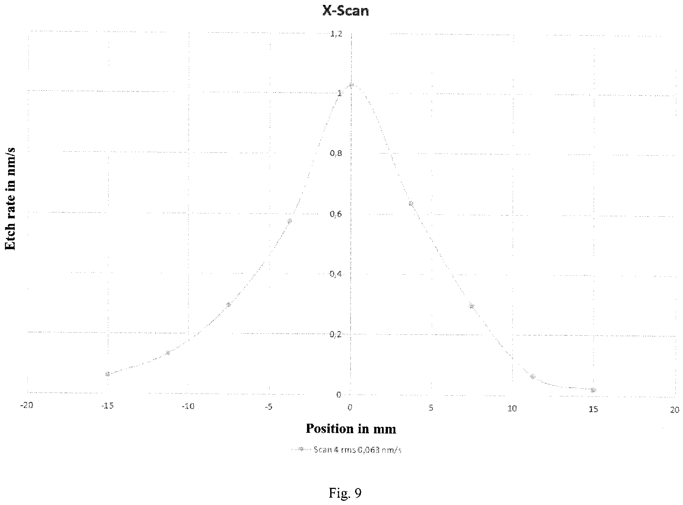

Fig. 9 illustrates etch rate measurements of different locations on the sample's surface and respective Gaussian fitting to obtain the etch rates of the ion beam profile, i.e. the volume etch rate. In Fig. 9, the y-axis shows the normalized etch rate values and the x-axis shows the displacement of the respective scan from the center.

A Gaussian fit is used to obtain the volume etch rate, which corresponds to the Gaussian profile of the ion beam. As can be seen, the present invention is used to determine the volume etc rates in-situ.

The point scan functionality of the present invention permits centering of the light directed to the sample's surface with respect to the ion beam by calculating the offset from the configured position. In addition, the ion beam etch rate geometry can be visualized, similar to the electric geometry visualization with Faraday scan. By using 3D Gaussian fit, volume etch rate can be calculated. The point scan is subject to the same restrictions as the epak etch rate measurement and thus exposure time for each point has to be chosen in a process requirement matching deviation grade.

As apparent from the above description, in-situ measurements can be used to determine the etch rate in-situ in a short time with process matching accuracy. No cost-intensive reference probe is necessary and the locking procedure dispenses. The sample can be reused many times before it has to be replaced and the sample material can be exchanged easily.

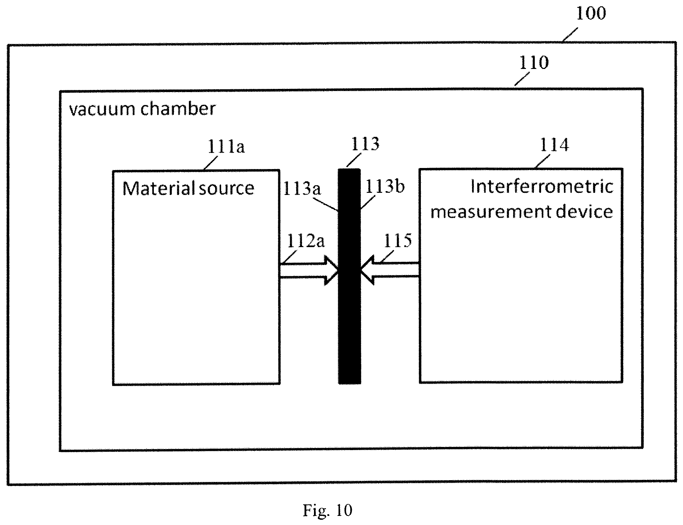

Fig. 10 shows a system 100 for in-situ deposition rate measurement. The system comprises a vacuum chamber 110, a material source 111a and an interferometric measurement device 114 not forming part of the claimed invention.

The material source 111a is configured to direct material 112a onto a first surface 113a of a sample 113 located within the vacuum chamber 110 and to deposit the material 112a onto the first surface 113a of the sample 113 with a certain deposition rate.

The interferometric measurement device 114 is located at least partially within the vacuum chamber 110 and configured to direct light 115 onto a second surface 113b of the sample 113 and to determine the deposition rate of the deposited material 112a in-situ based on light reflected from the sample 113.

The interferometric measurement device 114 may be the same one as described with reference to the etch rate determination. Thus, a further description at this point is omitted to avoid unnecessary repitions.

As the present invention may be embodied in several forms without departing from the scope or essential characteristics thereof, it should be understood that the above-described embodiments are not limited by any of the details of the foregoing descriptions, unless otherwise specified, but rather should be construed broadly within the scope as defined in the appended claims, and therefore all changes and modifications that fall within the present invention are therefore intended to be embraced by the appended claims.

Furthermore, in the claims the word "comprising" does not exclude other elements or steps, and the indefinite article "a" or "an" does not exclude a plurality. A single unit may fulfil the functions of several features recited in the claims. The terms "essentially", "about", "approximately" and the like in connection with an attribute or a value particularly also define exactly the attribute or exactly the value, respectively. Any reference signs in the claims should not be construed as limiting the scope.

## Claims

1. System (100) for in-situ ion beam volume etch rate measurement, comprising:
a vacuum chamber (110);
an ion beam source (111) configured to direct an ion beam (112) onto a first surface (113a) of a sample (113) located within the vacuum chamber (110) and to etch the first surface (113a) of the sample (113) with a volume etch rate;
an interferometric measurement device (114) located at least partially within the vacuum chamber (110) and configured to direct light (115) onto a second surface (113b) of the sample (113) and to determine the volume etch rate of the ion beam (112) in-situ based on light reflected from the sample (113), wherein the second surface (113b) of the sample (113) is opposite the first surface (113a) of the sample (113), wherein the interferometric measurement device (114) comprises a positioning device configured to position the light (115) at at least one predetermined location onto the second surface (113b) of the sample (113), and
a controller configured to control the positioning device to position the light (115) at the second surface (113b) of the sample (113) at a plurality of locations corresponding to locations within the ion beam profile to measure etch rates of the ion beam profile at different locations of the surface of the sample, wherein the controller is configured to perform a Gaussian fit of said measurements to obtain the volume etch rate which corresponds to the Gaussian profile of the ion beam.

2. The system (100) of claim 1, wherein the interferometric measurement device (114) is configured to determine the volume etch rate while etching the first surface (113a) of the sample (113).

3. The system (100) of any one of claims 1 to 2, wherein the interferometric measurement device (114) is a high precision optical low-coherence interferometer, HP-OLCI.

4. The system (100) of any one of claims 1 to 3, wherein the interferometric measurement device (114) is configured to determine the thickness of the sample (113) over time and to determine the volume etch rate based on the thickness variation of the sample (113) over time.

5. The system (100) of any one of claims 1 to 4, wherein the interferometric measurement device (114) comprises a sensor (117) configured to direct the light (115) onto the second surface (113b) of the sample (113) and to collect light reflected back from the sample (113).

6. The system (100) of claim 5, wherein the sensor (117) comprises optical components (116) to direct the light (115) onto the second surface (113b) of the sample (113) and to collect light reflected back from the sample (113) and preferably wherein the sensor (117) is located within the vacuum chamber (110) and preferably wherein the sensor (117) comprises the sample (113).

7. The system (100) of claim 6, wherein the sensor (117) comprises a housing and wherein the sample (113) is located inside the housing and preferably wherein the housing comprises an opening and the sample (113) is located at the opening such that the ion beam (112) can reach the sample's first surface (113a) through the opening.

8. The system (100) of claim 7, wherein the housing comprises a graphite outer surface.

9. The system (100) of any one of claims 1 to 8, wherein the interferometric measurement device (114) comprises a cooling device in contact with the sample (113) and configured to cool the sample (113).

10. The system (100) of any one of claims 1 to 9, wherein the controller is configured to control the positioning device to position the light (115) at the second surface (113b) of the sample (113) at a location corresponding to the center of the ion beam (112) to determine a peak etch rate of the ion beam (112).

11. The system (100) of any one of claims 1 to 10, further comprising an alignment device configured to align the ion beam (112) with respect to the first surface (113a) of the sample (113), wherein the alignment device prefereably comprises a Faraday cup and a position camera or a characterization device configured to characterize the ion beam by a point-scan and calculate the offset to an initial start point.

12. Method for in-situ ion beam volume etch rate measurement, wherein the method comprises:
directing an ion beam (112) onto a first surface (113a) of a sample (113) located within a vacuum chamber (110) to etch the first surface (133a) of the sample (113) with a volume etch rate;
directing light (115) of an interferometric measurement device (114) located at least partially within the vacuum chamber (110) onto a second surface (113b) of the sample (113) wherein the second surface (113b) of the sample (113) is opposite the first surface (113a) of the sample (113), wherein the light (115) is positioned at the second surface (113b) of the sample (113) at a plurality of locations corresponding to locations within the ion beam profile to measure etch rates of the ion beam profile at different locations of the surface of the sample,; and
determining the volume etch rate of the ion beam (112) in-situ based on light reflected from the sample (113),wherein a Gaussian fit of said measurements is performed to obtain the volume etch rate which corresponds to the Gaussian profile of the ion beam.

## Patentansprüche

1. System (100) für eine In-situ-Messung einer Ionenstrahlvolumenätzrate, aufweisend:
eine Vakuumkammer (110);
eine Ionenstrahlquelle (111), die konfiguriert ist, um einen Ionenstrahl (112) auf eine erste Oberfläche (113a) einer Probe (113) zu richten, die sich innerhalb der Vakuumkammer (110) befindet, und um die erste Oberfläche (113a) der Probe (113) mit einer Volumenätzrate zu ätzen;
eine interferometrische Messvorrichtung (114), die sich mindestens teilweise innerhalb der Vakuumkammer (110) befindet und konfiguriert ist, um Licht (115) auf eine zweite Oberfläche (113b) der Probe (113) zu richten und um die Volumenätzrate des Ionenstrahls (112) in-situ basierend auf Licht zu bestimmen, das von der Probe (113) reflektiert wird, wobei die zweite Oberfläche (113b) der Probe (113) der ersten Oberfläche (113a) der Probe (113) gegenüberliegt, wobei die interferometrische Messvorrichtung (114) eine Positionierungsvorrichtung aufweist, die konfiguriert ist, um das Licht (115) an mindestens einer vorbestimmten Stelle auf der zweiten Oberfläche (113b) der Probe (113) zu positionieren, und
eine Steuerung, die konfiguriert ist, um die Positionierungsvorrichtung zu steuern, um das Licht (115) an der zweiten Oberfläche (113b) der Probe (113) an mehreren Stellen zu positionieren, die Stellen innerhalb des Ionenstrahlprofils entsprechen, um Ätzraten des Ionenstrahlprofils an unterschiedlichen Stellen der Oberfläche der Probe zu messen, wobei die Steuerung konfiguriert ist, um eine Gauß-Anpassung der Messungen durchzuführen, um die Volumenätzrate zu erhalten, die dem Gauß-Profil des Ionenstrahls entspricht.

2. System (100) nach Anspruch 1, wobei die interferometrische Messvorrichtung (114) konfiguriert ist, um die Volumenätzrate während des Ätzens der ersten Oberfläche (113a) der Probe (113) zu bestimmen.

3. System (100) nach einem der Ansprüche 1 bis 2, wobei die interferometrische Messvorrichtung (114) ein hochpräzises optisches Niederkohärenzinterferometer, HP-OLCI, ist.

4. System (100) nach einem der Ansprüche 1 bis 3, wobei die interferometrische Messvorrichtung (114) konfiguriert ist, um die Dicke der Probe (113) im Laufe der Zeit zu bestimmen und die Volumenätzrate basierend auf der Variation der Dicke der Probe (113) im Laufe der Zeit zu bestimmen.

5. System (100) nach einem der Ansprüche 1 bis 4, wobei die interferometrische Messvorrichtung (114) einen Sensor (117) aufweist, der konfiguriert ist, um das Licht (115) auf die zweite Oberfläche (113b) der Probe (113) zu richten und um Licht zu sammeln, das von der Probe (113) zurückreflektiert wird.

6. System (100) nach Anspruch 5, wobei der Sensor (117) optische Komponenten (116) aufweist, um das Licht (115) auf die zweite Oberfläche (113b) der Probe (113) zu richten und um Licht zu sammeln, das von der Probe (113) zurückreflektiert wird, und wobei vorzugsweise sich der Sensor (117) innerhalb der Vakuumkammer (110) befindet und wobei vorzugsweise der Sensor (117) die Probe (113) aufweist.

7. System (100) nach Anspruch 6, wobei der Sensor (117) ein Gehäuse aufweist und wobei sich die Probe (113) im Inneren des Gehäuses befindet und wobei vorzugsweise das Gehäuse eine Öffnung aufweist und sich die Probe (113) an der Öffnung derart befindet, dass der Ionenstrahl (112) die erste Oberfläche (113a) der Probe durch die Öffnung erreichen kann.

8. System (100) nach Anspruch 7, wobei das Gehäuse eine Graphitaußenoberfläche aufweist.

9. System (100) nach einem der Ansprüche 1 bis 8, wobei die interferometrische Messvorrichtung (114) eine Kühlvorrichtung aufweist, die in Kontakt mit der Probe (113) steht und konfiguriert ist, um die Probe (113) zu kühlen.

10. System (100) nach einem der Ansprüche 1 bis 9, wobei die Steuerung konfiguriert ist, um die Positionierungsvorrichtung zu steuern, um das Licht (115) an der zweiten Oberfläche (113b) der Probe (113) an einer Stelle zu positionieren, die der Mitte des Ionenstrahls (112) entspricht, um eine Spitzenätzrate des Ionenstrahls (112) zu bestimmen.

11. System (100) nach einem der Ansprüche 1 bis 10, ferner aufweisend eine Ausrichtungsvorrichtung, die konfiguriert ist, um den Ionenstrahl (112) hinsichtlich der ersten Oberfläche (113a) der Probe (113) auszurichten, wobei die Ausrichtungsvorrichtung vorzugsweise einen Faraday-Becher und eine Positionskamera oder eine Charakterisierungsvorrichtung aufweist, die konfiguriert ist, um den Ionenstrahl durch eine Punktabtastung zu charakterisieren und den Versatz zu einem anfänglichen Startpunkt zu berechnen.

12. Verfahren für die In-situ-Messung der Ionenstrahlvolumenätzrate, wobei das Verfahren aufweist:
Richten eines Ionenstrahls (112) auf eine erste Oberfläche (113a) einer Probe (113), die sich innerhalb einer Vakuumkammer (110) befindet, um die erste Oberfläche (133a) der Probe (113) mit einer Volumenätzrate zu ätzen;
Richten von Licht (115) einer interferometrischen Messvorrichtung (114), die sich mindestens teilweise innerhalb der Vakuumkammer (110) befindet, auf eine zweite Oberfläche (113b) der Probe (113), wobei die zweite Oberfläche (113b) der Probe (113) der ersten Oberfläche (113a) der Probe (113) gegenüberliegt, wobei das Licht (115) an der zweiten Oberfläche (113b) der Probe (113) an mehreren Stellen positioniert wird, die Stellen innerhalb des Ionenstrahlprofils entsprechen, um Ätzraten des Ionenstrahlprofils an unterschiedlichen Stellen der Oberfläche der Probe zu messen; und
Bestimmen der Volumenätzrate des Ionenstrahls (112) in-situ basierend auf Licht, das von der Probe (113) reflektiert wird, wobei eine Gauß-Anpassung der Messungen durchgeführt wird, um die Volumenätzrate zu erhalten, die dem Gauß-Profil des Ionenstrahls entspricht.

## Revendications

1. Système (100) de mesure de vitesse de gravure en volume de faisceau d'ions in situ, comprenant :
une chambre à vide (110) ;
une source de faisceau d'ions (111) configurée pour diriger un faisceau d'ions (112) sur une première surface (113a) d'un échantillon (113) situé à l'intérieur de la chambre à vide (110) et pour graver la première surface (113a) de l'échantillon (113) avec une vitesse de gravure en volume ;
un dispositif de mesure interférométrique (114) situé au moins partiellement à l'intérieur de la chambre à vide (110) et configuré pour diriger la lumière (115) sur une seconde surface (113b) de l'échantillon (113) et pour déterminer la vitesse de gravure en volume du faisceau d'ions (112) in situ sur la base de la lumière réfléchie par l'échantillon (113), dans lequel la seconde surface (113b) de l'échantillon (113) est opposée à la première surface (113a) de l'échantillon (113), dans lequel le dispositif de mesure interférométrique (114) comprend un dispositif de positionnement configuré pour positionner la lumière (115) au niveau d'au moins un emplacement prédéterminé sur la seconde surface (113b) de l'échantillon (113), et
un dispositif de commande configuré pour commander le dispositif de positionnement afin de positionner la lumière (115) au niveau de la seconde surface (113b) de l'échantillon (113) au niveau d'une pluralité d'emplacements correspondant à des emplacements à l'intérieur du profil de faisceau d'ions pour mesurer des vitesses de gravure du profil de faisceau d'ions au niveau de différents emplacements de la surface de l'échantillon, dans lequel le dispositif de commande est configuré pour réaliser un ajustement gaussien desdites mesures afin d'obtenir la vitesse de gravure en volume qui correspond au profil gaussien du faisceau d'ions.

2. Système (100) selon la revendication 1, dans lequel le dispositif de mesure interférométrique (114) est configuré pour déterminer la vitesse de gravure en volume lors de la gravure de la première surface (113a) de l'échantillon (113).

3. Système (100) selon l'une quelconque des revendications 1 à 2, dans lequel le dispositif de mesure interférométrique (114) est un interféromètre optique à faible cohérence de haute précision, HP-OLCI.

4. Système (100) selon l'une quelconque des revendications 1 à 3, dans lequel le dispositif de mesure interférométrique (114) est configuré pour déterminer l'épaisseur de l'échantillon (113) au fil du temps et pour déterminer la vitesse de gravure en volume sur la base de la variation d'épaisseur de l'échantillon (113) au fil du temps.

5. Système (100) selon l'une quelconque des revendications 1 à 4, dans lequel le dispositif de mesure interférométrique (114) comprend un capteur (117) configuré pour diriger la lumière (115) sur la seconde surface (113b) de l'échantillon (113) et pour collecter la lumière réfléchie par l'échantillon (113).

6. Système (100) selon la revendication 5, dans lequel le capteur (117) comprend des composants optiques (116) pour diriger la lumière (115) sur la seconde surface (113b) de l'échantillon (113) et pour collecter la lumière réfléchie par l'échantillon (113) et dans lequel de préférence le capteur (117) est situé à l'intérieur de la chambre à vide (110) et dans lequel de préférence le capteur (117) comprend l'échantillon (113).

7. Système (100) selon la revendication 6, dans lequel le capteur (117) comprend un boîtier et dans lequel l'échantillon (113) est situé à l'intérieur du boîtier et dans lequel de préférence le boîtier comprend une ouverture et l'échantillon (113) est situé au niveau de l'ouverture de telle sorte que le faisceau d'ions (112) peut atteindre la première surface (113a) de l'échantillon à travers l'ouverture.

8. Système (100) selon la revendication 7, dans lequel le boîtier comprend une surface externe en graphite.

9. Système (100) selon l'une quelconque des revendications 1 à 8, dans lequel le dispositif de mesure interférométrique (114) comprend un dispositif de refroidissement en contact avec l'échantillon (113) et configuré pour refroidir l'échantillon (113).

10. Système (100) selon l'une quelconque des revendications 1 à 9, dans lequel le dispositif de commande est configuré pour commander le dispositif de positionnement afin de positionner la lumière (115) au niveau de la seconde surface (113b) de l'échantillon (113) au niveau d'un emplacement correspondant au centre du faisceau d'ions (112) pour déterminer une vitesse de gravure de pic du faisceau d'ions (112).

11. Système (100) selon l'une quelconque des revendications 1 à 10, comprenant en outre un dispositif d'alignement conçu pour aligner le faisceau d'ions (112) par rapport à la première surface (113a) de l'échantillon (113), dans lequel le dispositif d'alignement comprend de préférence un collecteur de Faraday et une caméra de position ou un dispositif de caractérisation configuré pour caractériser le faisceau d'ions par un balayage ponctuel et calculer le décalage vers un point de départ initial.

12. Procédé de mesure de vitesse de gravure en volume de faisceau d'ions in situ, dans lequel le procédé comprend :
la direction d'un faisceau d'ions (112) sur une première surface (113a) d'un échantillon (113) située à l'intérieur d'une chambre à vide (110) pour graver la première surface (133a) de l'échantillon (113) avec une vitesse de gravure en volume ;
la direction de la lumière (115) d'un dispositif de mesure interférométrique (114) situé au moins partiellement à l'intérieur de la chambre à vide (110) sur une seconde surface (113b) de l'échantillon (113), dans lequel la seconde surface (113b) de l'échantillon (113) est opposée à la première surface (113a) de l'échantillon (113), dans lequel la lumière (115) est positionnée au niveau de la seconde surface (113b) de l'échantillon (113) au niveau d'une pluralité d'emplacements correspondant à des emplacements dans le profil de faisceau d'ions pour mesurer des vitesses de gravure du profil de faisceau d'ions au niveau de différents emplacements de la surface de l'échantillon ; et
la détermination de la vitesse de gravure en volume du faisceau d'ions (112) in situ sur la base de la lumière réfléchie par l'échantillon (113), dans lequel un ajustement gaussien desdites mesures est réalisé pour obtenir la vitesse de gravure en volume qui correspond au profil gaussien du faisceau d'ions.
